(19) Europäisches Patentamt
European Patent Office
Office européen des brevets

(11) **EP 3 032 757 A2**

(12) **EUROPEAN PATENT APPLICATION**

(43) Date of publication:
**15.06.2016 Bulletin 2016/24**

(51) Int Cl.:
***H04B 5/00*** *(2006.01)*

(21) Application number: **15189435.9**

(22) Date of filing: **12.10.2015**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(30) Priority: **12.12.2014 US 201462091184 P**

(71) Applicant: **United Technologies Corporation
Farmington, CT 06032 (US)**

(72) Inventors:
- **TOKGOZ, Cagatay
  South Windsor, CT Connecticut 06074 (US)**
- **ZACCHIO, Joseph
  Wethersfield, CT Connecticut 06109 (US)**
- **WU, Xin
  Glastonbury, CT Connecticut 06033 (US)**
- **SOLDNER, Nicholas C.
  Southbury, CT Connecticut 06488 (US)**
- **MANTESE, Joseph V.
  Ellington, CT Connecticut 06029 (US)**

(74) Representative: **Hull, James Edward
Dehns
St. Bride's House
10 Salisbury Square
London
EC4Y 8JD (GB)**

(54) **SYSTEM AND METHOD FOR COIL SENSOR DESIGN, ALIGNMENT AND TUNING**

(57)     A sensor includes inductively coupled coils (100, 104). Alignment of the coils (100, 104) may be maintained by constraining relative movement of the structures (102, 106) into which each of the coils (100, 104) is embedded. Alignment of the coils (100, 104) may be established by maintaining the transponder coil (104) stationary while moving the reader coil (100) with respect to the transponder coil (104) and monitoring the current at the source supplying the reader coil (100). When the current at the source is at an extreme value (substantially maximized or minimized), the reader coil (100) and the transponder coil (104) are aligned. Additionally disclosed is an iterative process for designing coil geometries and resonant circuits for a sensor employing inductively coupled coils (100, 104).

Fig. 3

EP 3 032 757 A2

# Description

## TECHNICAL FIELD OF THE DISCLOSURE

The present disclosure is generally related to coil sensors and, more specifically, to a system and method for coil sensor design, alignment and tuning.

## BACKGROUND OF THE DISCLOSURE

Inductively coupled coils are used to transmit power and/or data across a gap between the coils. A common example is a radio frequency identification (RFID) transponder and its associated reader. Alternating current is passed through a first coil in the reader, which causes the generation of a magnetic field around the first coil. A second coil in the transponder, when disposed in the magnetic field, will have a voltage induced thereon by a process known as electromagnetic induction. This voltage may be used to power an electronic circuit coupled to the second coil, such as the data transmission circuitry of an RFID transponder.

Inductive coupling requires design, tuning and alignment of coils to achieve sufficiently high coupling and quality factors for reliable power transfer and communications. In many applications, sensors employing coils, as well as any wireless power and data transmission systems connected to them, need to be embedded into structural components to protect them from environmental effects, to prevent them from disturbing air or fluid flow, and/or to detect whether the structural components are original or counterfeit. Such positioning makes it challenging to align the reader coil and the sensor coil during installation and operation, especially when soft ferrite cores are used to improve coupling between the coils. When a coil is embedded in a metallic structure, the coil can easily be detuned by the presence of the structure. When two coils are positioned close to each other, they can significantly detune each other. Environmental effects such as temperature variations and vibrations also contribute to the detuning of coils. Environmental effects change at differing rates for each component. For example, temperature variations can affect coil resistance, which will change the quality factor of the coil. As another example, vibration of the structure in which a coil is embedded can alter the separation between coils and their alignment, which may result in significant changes in the coupling factor and quality factors of the coils. Therefore, coils and their associated resonant circuits need to be designed in such a way that they can operate in a wide range of operating conditions. If needed, separate components can be used to compensate for environmental effects.

Improvements in sensor design and tuning are therefore needed in the art.

## SUMMARY OF THE DISCLOSURE

In one embodiment, an inductively coupled sensor is disclosed comprising: a first structure; a reader coil substantially disposed about an axis and at least partially embedded in the first structure; a second structure; a transponder coil substantially disposed about the axis at least partially embedded in the second structure; and a member operatively coupled to the first structure and to the second structure, the member constructed and arranged to constrain movement of the first structure with respect to the second structure.

In another embodiment of the above, the member comprises a rigid member.

In another embodiment of any of the above, the member allows rotational movement of the first structure with respect to the second structure.

In another embodiment of any of the above, the member allows movement along the axis of the first structure with respect to the second structure.

In another embodiment of any of the above, the member is operative to slide with respect to the first structure in order to permit movement along the axis of the first structure with respect to the second structure.

In another embodiment of any of the above, a channel is disposed within the first structure; a portion of the member is disposed within the channel; and the member is operative to slide within the channel in order to permit movement along the axis of the first structure with respect to the second structure.

In another embodiment, a method for aligning an inductively coupled sensor comprising a reader coil, a reader resonant circuit, a transponder coil, and a transponder resonant circuit is disclosed, the method comprising: (a) maintaining one of the transponder coil and the reader coil stationary; (b) exciting the reader coil at a frequency and a first voltage amplitude; (c) changing a position of an other of the transponder coil and the reader coil with respect to the coil maintained stationary in step (a); (d) measuring a current in the reader resonant circuit at a present position of the transponder coil and the reader coil; (e) determining if the current in the reader resonant circuit is substantially at a first extreme value; (f) if it is determined at step (e) that the current in the reader resonant circuit is substantially at the first extreme value, determining that the present positions of the reader coil and the transponder coil are aligned; and (g) if it is determined at step (e) that the current in the reader resonant circuit is not substantially at the first extreme value, repeating steps (c) - (g).

In another embodiment of any of the above, a method for tuning the inductively coupled sensor is disclosed, the method for tuning comprising: (h) sweeping a frequency of a voltage source of the reader coil across a predetermined range of frequencies; (i) determining a reader resonant circuit resonant frequency within the predetermined range of frequencies at which a voltage induced across the transponder coil is substantially maximized; and (j) adjusting a tuning of the transponder resonant circuit such that a transponder resonant circuit resonant frequency is substantially the same as the reader resonant circuit resonant frequency.

In another embodiment of any of the above, step (j) comprises: (j.1) applying a first current to the transponder resonant circuit; (j.2) determining second current induced in the reader coil by the first current; (j.3) adjusting a capacitance of the transponder resonant circuit; (j.4) determining a third current in the reader resonant circuit required to produce the first current in the transponder resonant circuit; (j.5) determining if the third current in the reader resonant circuit is substantially at a second extreme value; (j.6) determining that the reader resonant circuit resonant frequency is substantially the same as the transponder resonant circuit resonant frequency, based on determining at step (j.5) that the third current in the reader resonant circuit is substantially at the second extreme value; and (j.7) repeating steps (j.3) - (j.6) based on determining at step (j.5) that the third current in the reader resonant circuit is not substantially at the second extreme value.

In another embodiment of any of the above, the reader resonant circuit comprises series resonance and the transponder resonant circuit comprises parallel resonance.

In another embodiment of any of the above, step (j.3) comprises adjusting a voltage applied to a voltage controlled variable capacitance within the transponder resonant circuit.

In another embodiment of any of the above, the voltage controlled variable capacitance comprises a varactor diode.

In another embodiment, a method for designing an inductively coupled sensor comprising a reader coil, a reader resonant circuit, a transponder coil, and a transponder resonant circuit that satisfy a predetermined power transfer requirement and a predetermined power transfer efficiency requirement is disclosed, the method comprising: (a) determining a minimum output voltage and a maximum output voltage for powering a device coupled to the transponder coil; (b) determining a mutual inductance, a coupling factor, a reader coil inductance and a transponder coil inductance; (c) determining a reader coil design and a transponder coil design; (d) determining whether the reader coil design and the transponder coil design satisfy the predetermined power transfer requirement; (e) selecting a different value for at least one of an unloaded reader coil quality factor, a loaded reader coil quality factor, an unloaded transponder coil quality factor, and a loaded transponder coil quality factor and repeating steps (a) - (g), based on determining at step (d) that the reader coil design and the transponder coil design do not satisfy the predetermined power transfer requirement; (f) determining whether the reader coil design and the transponder coil design satisfy the predetermined power transfer efficiency requirement, based on determining at step (d) that the reader coil design and the transponder coil design do satisfy the predetermined power transfer requirement; and (g) selecting a different value for at least one of the unloaded reader coil quality factor, the loaded reader coil quality factor, the unloaded transponder coil quality factor, and the loaded transponder coil quality factor and repeating steps (a) - (g), based on determining at step (f) that the reader coil design and the transponder coil design satisfy the predetermined power transfer efficiency requirement.

In another embodiment of any of the above, step (c) comprises determining a reader coil core geometry design, a number of reader coil winding turns, the reader coil winding properties, a reader resonant circuit design, a transponder coil core geometry design, a number of transponder coil winding turns, the transponder coil winding properties, and a transponder resonant circuit design.

Other embodiments are also disclosed.

## BRIEF DESCRIPTION OF THE DRAWINGS

The embodiments and other features, advantages and disclosures contained herein, and the manner of attaining them, will become apparent and the present disclosure will be better understood by reference to the following description of various exemplary embodiments of the present disclosure taken in conjunction with the accompanying drawings, wherein:

FIG. 1 is a schematic cross-sectional view of a gas turbine engine.
FIG. 2 is a schematic diagram of two inductively coupled coils in an embodiment.
FIG. 3 is a schematic perspective view of two inductively coupled coils in an embodiment.
FIG. 4 is a schematic perspective view of coupling member in an embodiment.
FIG. 5 is a schematic process diagram of a coil alignment process in an embodiment.
FIG. 6 is a schematic circuit diagram of two inductively coupled coils in an embodiment.
FIG. 7 is a schematic process diagram of a coil and resonant circuit design process in an embodiment.

## DETAILED DESCRIPTION OF THE DISCLOSED EMBODIMENTS

For the purposes of promoting an understanding of the principles of the disclosure, reference will now be made to certain embodiments and specific language will be used to describe the same. It will nevertheless be understood that no limitation of the scope of the disclosure is thereby intended, and alterations and modifications in the illustrated device, and further applications of the principles of the disclosure as illustrated therein are herein contemplated as would normally occur to one skilled in the art to which the disclosure relates.

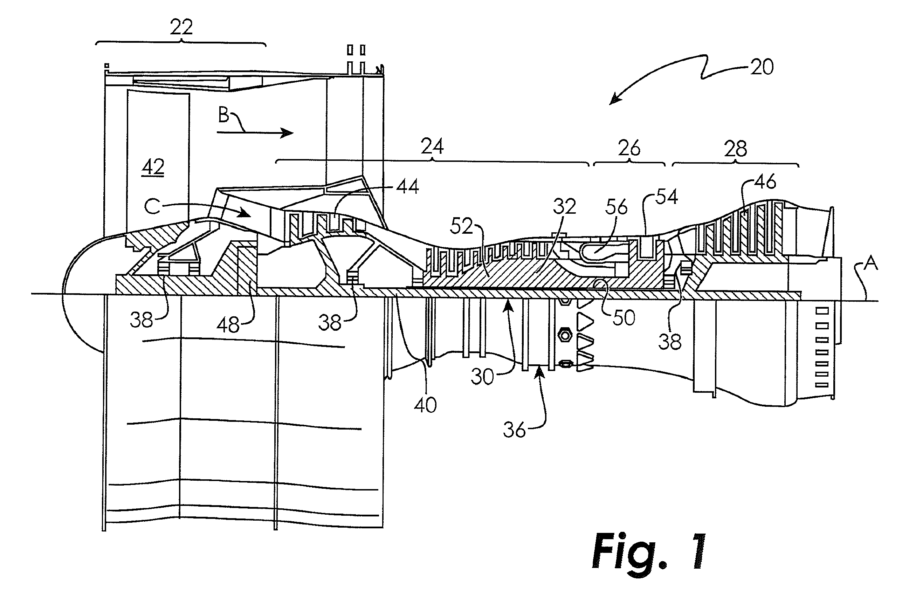

FIG. 1 schematically illustrates a gas turbine engine 20. The gas turbine engine 20 is disclosed herein as a two-spool turbofan that generally incorporates a fan section 22, a compressor section 24, a combustor section 26 and a turbine section 28. Alternative engines might include an augmentor section (not shown) among other systems or features. The fan section 22 drives air along a bypass flow path B in a bypass duct, while the compressor section 24 drives air along a core flow path C for compression and communication into the combustor section 26 then expansion through the turbine section 28. Although depicted as a two-spool turbofan gas turbine engine in the disclosed non-limiting embodiment, it should be understood that the concepts described herein are not limited to use with two-spool turbofans as the teachings may be applied to other types of turbine engines including three-spool architectures.

The exemplary engine 20 generally includes a low speed spool 30 and a high speed spool 32 mounted for rotation about an engine central longitudinal axis A relative to an engine static structure 36 via several bearing systems 38. It should be understood that various bearing systems 38 at various locations may alternatively or additionally be provided, and the location of bearing systems 38 may be varied as appropriate to the application.

The low speed spool 30 generally includes an inner shaft 40 that interconnects a fan 42, a low pressure compressor 44 and a low pressure turbine 46. The inner shaft 40 is connected to the fan 42 through a speed change mechanism, which in exemplary gas turbine engine 20 is illustrated as a geared architecture 48 to drive the fan 42 at a lower speed than the low speed spool 30. The high speed spool 32 includes an outer shaft 50 that interconnects a high pressure compressor 52 and high pressure turbine 54. A combustor 56 is arranged in exemplary gas turbine 20 between the high pressure compressor 52 and the high pressure turbine 54. An engine static structure 36 is arranged generally between the high pressure turbine 54 and the low pressure turbine 46. The engine static structure 36 further supports bearing systems 38 in the turbine section 28. The inner shaft 40 and the outer shaft 50 are concentric and rotate via bearing systems 38 about the engine central longitudinal axis A which is collinear with their longitudinal axes.

The core airflow is compressed by the low pressure compressor 44 then the high pressure compressor 52, mixed and burned with fuel in the combustor 56, then expanded over the high pressure turbine 54 and low pressure turbine 46. The turbines 46, 54 rotationally drive the respective low speed spool 30 and high speed spool 32 in response to the expansion. It will be appreciated that each of the positions of the fan section 22, compressor section 24, combustor section 26, turbine section 28, and fan drive gear system 48 may be varied. For example, gear system 48 may be located aft of combustor section 26 or even aft of turbine section 28, and fan section 22 may be positioned forward or aft of the location of gear system 48.

The engine 20 in one example is a high-bypass geared aircraft engine. In a further example, the engine 20 bypass ratio is greater than about six (6:1), with an example embodiment being greater than about ten (10:1), the geared architecture 48 is an epicyclic gear train, such as a planetary gear system or other gear system, with a gear reduction ratio of greater than about 2.3 and the low pressure turbine 46 has a pressure ratio that is greater than about five (5:1). In one disclosed embodiment, the engine 20 bypass ratio is greater than about ten (10:1), the fan diameter is significantly larger than that of the low pressure compressor 44, and the low pressure turbine 46 has a pressure ratio that is greater than about five (5:1). Low pressure turbine 46 pressure ratio is pressure measured prior to inlet of low pressure turbine 46 as related to the pressure at the outlet of the low pressure turbine 46 prior to an exhaust nozzle. The geared architecture 48 may be an epicycle gear train, such as a planetary gear system or other gear system, with a gear reduction ratio of greater than about 2.3:1. It should be understood, however, that the above parameters are only exemplary of one embodiment of a geared architecture engine and that the present invention is applicable to other gas turbine engines including direct drive turbofans.

A significant amount of thrust is provided by the bypass flow B due to the high bypass ratio. The fan section 22 of the engine 20 is designed for a particular flight condition -- typically cruise at about 0.8 Mach and about 35,000 feet (10,688 meters). The flight condition of 0.8 Mach and 35,000 ft (10,688 meters), with the engine at its best fuel consumption - also known as "bucket cruise Thrust Specific Fuel Consumption ('TSFC')" - is the industry standard parameter of lbm of fuel being burned divided by lbf of thrust the engine produces at that minimum point. "Low fan pressure ratio" is the pressure ratio across the fan blade alone, without a Fan Exit Guide Vane ("FEGV") system. The low fan pressure ratio as disclosed herein according to one non-limiting embodiment is less than about 1.45. "Low corrected fan tip speed" is the actual fan tip speed in ft/sec divided by an industry standard temperature correction of $[(Tram °R) / (518.7 °R)]^{0.5}$. The "Low corrected fan tip speed" as disclosed herein according to one non-limiting embodiment is less than about 1150 ft / second (350.5 m/sec).

Inductive power transfer works by creating an alternating magnetic field (flux) in a reader coil and converting that flux into an electrical current in the transponder coil. Depending on the distance between the transmitting and receiving coils, only a fraction of the magnetic flux generated by the reader coil penetrates the transponder coil and contributes to the power transmission. The more flux that reaches the transponder, the better the coils are coupled. Assuming proper compensation has been done, a higher coupling factor improves the transfer efficiency, and reduces losses and heating.

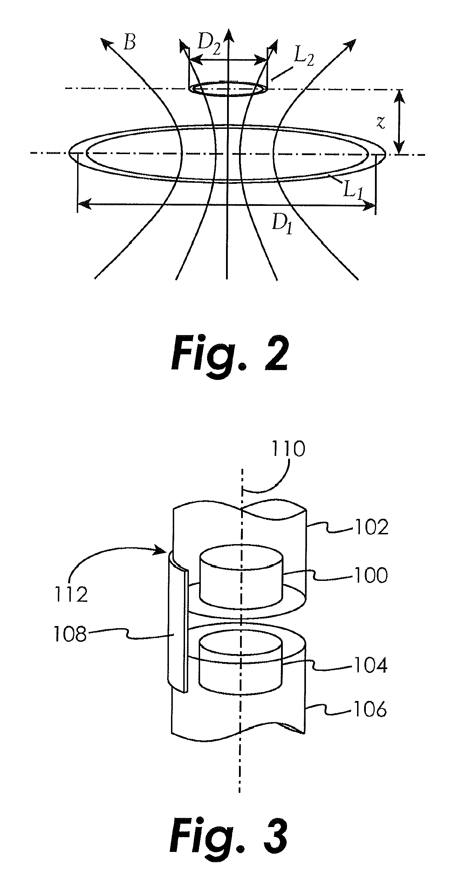

The basic principle of an inductively coupled power transfer system is shown in FIG. 2, which schematically illustrates a reader coil L1 and a transponder coil L2. The coils L1, L2 form a system of magnetically coupled inductors. An alternating current in the reader coil L1 generates a magnetic field B which induces a voltage in the transponder coil L2. The efficiency of the power transfer depends on the coupling factor (k) between the coils L1, L2 and their quality factor (Q), provided that other variables such as the medium in the vicinity of the coils L1, L2, coil alignment, coil loading and frequency remain constant. The coupling factor k is modified by the distance between the coils L1, L2 (z) and the ratio of their coupling areas, as well as other variables that affect the magnetic path, such as the medium in the path of coupling, coil alignment, and frequency.

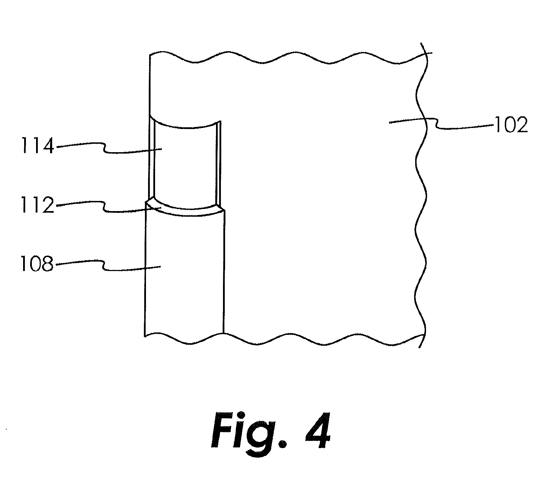

Coil alignment contributes to effective power and data transfer between the reader coil L1 and the transponder coil L2. When one or both of the coils are embedded in a structure, it can be challenging to align them properly during installation. As shown in FIG. 3, a first coil 100 (such as a reader coil) is embedded in a first structure 102, while a second coil 104 (such as a transponder coil) is embedded in a second structure 106. Alignment of the coils 100, 104 may be maintained by physically constraining the movement of the first structure 102 with respect to the second structure 106. For example, one or more rigid members 108 may be attached to both the first structure 102 and the second structure 106 in an embodiment, thereby preventing relative movement between the structures 102, 106. The representation of rigid member 108 in FIG. 3 is schematic, as relative movement of the structures 102, 106 may be constrained in multiple ways. Coil 100, 104 alignment is not affected by rotation of first structure 102 with respect to the second structure 106 about their common longitudinal axis 110, therefore the rigid member 108 need not prevent such relative rotational motion in all embodiments. Additionally, movement of either or both of the structures 102, 106 toward and/or away from one another along the axis 110 will not affect their alignment, although it will affect their coupling factor and resonant frequencies. Therefore, in some embodiments where some relative motion between the structures 102, 106 must be allowed for other design reasons, the rigid member 108 may be designed to allow at least some range of motion of the structures 102, 106 along the axis 110, such as by allowing the end 112 of the rigid member 108 to slide with respect to the first structure 102 in a constrained manner that maintains the first structure 102 on the axis 110, such as by constraining the rigid member 108 within a channel 114 formed in the first structure 102 as shown in FIG. 4, to name just one non-limiting example.

Efforts to maintain the alignment of the coils 100, 104 require that the coils 100, 104 were previously in alignment and at resonance when aligned. As the coils 100, 104 move toward alignment, the reader coil 100 will go back to resonance which will tend to maximize the current in the reader coil 100. At the same time, the loading effect due to the presence of the transponder coil 104 will tend to minimize the current in the reader coil 100.

Design parameters will determine which effect dominates. If the load power is low and the loaded quality factor of the reader coil 100 is sufficiently high, then the current in the reader coil 100 will maximize when moving closer to alignment. Conversely, if the load power is sufficiently high and the loaded quality factor of the reader coil 100 is low, then the current in the reader coil 100 will minimize when moving closer to alignment. Therefore, the current in the reader coil 100 is expected to reach an "extreme value" (i.e., maximum or minimum) based on the design parameters.

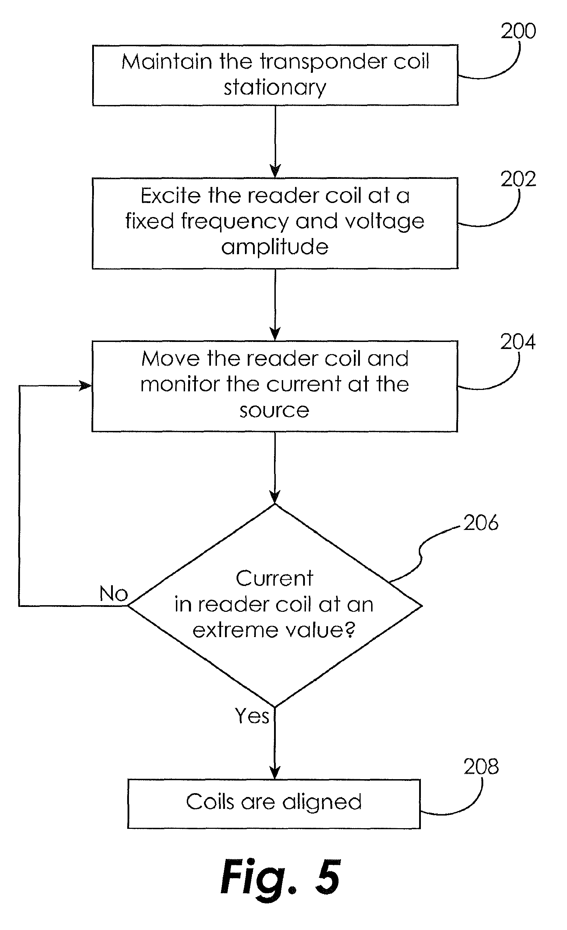

In various embodiments, both, only one, or neither of the coils 100, 104 is embedded within a structure. Alignment of the coils can be achieved by monitoring the loading of the reader coil 100 as it is moved relative to the transponder coil 104, using the process illustrated in FIG. 5, according to an embodiment. At block 200, the transponder coil 104 is maintained in stationary position. At block 202, the reader coil 100 is excited at a predetermined frequency and voltage amplitude. At block 204, the reader coil 100 is moved with respect to the transponder coil 104 while monitoring the current at the source used to excite the reader coil 100. When the two coils 100, 104 are aligned, the loading effect will be back to optimum and the coils 100, 104 will be resonant and hence the current in the reader coil 100 will be at an extreme value. Therefore, at block 206 it is determined whether the current in the reader coil 100 is at an extreme value. Block 206 may in some embodiments locate only a local extreme value current and not an absolute extreme value current of the system. Movement of the reader coil 100 may be accomplished manually and/or with use of device (not shown) adapted to move the reader coil 100 during the process of locating the extreme value current. If the current in the reader coil 100 is not at an extreme value, the process returns to block 204 and the reader coil 100 is moved again in an attempt to find the position that produces the extreme value of current in the reader coil 100. If, on the other hand, it is determined at block 206 that the current in the reader coil 100 is at an extreme value, the process moves to block 208 where it is determined that the coils 100, 104 are aligned. In other embodiments, the reader coil 100 is maintained stationary while the transponder coil 104 is moved.

Each of the coils 100, 104 is coupled to a resonant circuit where the resonant frequency is based on the inductance and capacitance of the resonant circuit as well as the overall quality factor. The tuning of the coils 100, 104 may therefore be monitored and compensated if needed. Such monitoring and compensation may be periodically performed by the system in which the coils 100, 104 are connected. Misalignment of the reader coil 100 and the transponder coil 104 will affect their tuning, and adjustment of the tuning of either or both of the coils 100, 104 may provide enough improvement in a low quality factor environment. The tuning, and therefore the resonant frequency, can be changed by changing the capacitance of the resonant circuit. For example, a varactor diode may be used in the resonant circuit to provide a voltage controlled variable capacitance. Digital communications between the coils 100, 104 can enable automatic tuning after the battery-free device connected to the transponder coil 104 is powered by the reader coil 100 through inductive coupling. This requires that the coupling between the coils 100, 104 is sufficient to power the device coupled to the transponder coil 104 so that it can enter an auto-tuning routine. After receiving enough energy to enter an auto-tuning routine, the device coupled to the transponder coil 104 can use digital communications to command the device coupled to the reader coil 100 to adjust its tuning while monitoring the load to find an optimal tuning. For example, the frequency of the voltage source in the reader coil 100 circuit can be swept across a range of values and the frequency at which the voltage induced across the transponder coil 104 is the highest is the resonant frequency for the system. Likewise, the device coupled to the reader coil 100 may command the device coupled to the transponder coil 104 to adjust its own tuning. For example, the current induced in the reader coil 100 from a fixed load current in the transponder coil 104 circuit can be measured. This current value can be used to determine the coupling factor between the two coils 100, 104. This current can also be used as a reference to adjust the transponder coil 104 circuit resonance capacitance value. Once the transponder coil 104 circuit has the same resonant frequency as the reader coil 100 circuit, the current in the reader coil 100 circuit required to supply the same fixed load current in the transponder coil 104 circuit is maximized. The overhead required for commanding such tuning can be as simple as a single bit flag where a 0 can be interpreted as "tune down" and a 1 can be interpreted as a "tune up", to name just one non-limiting example.

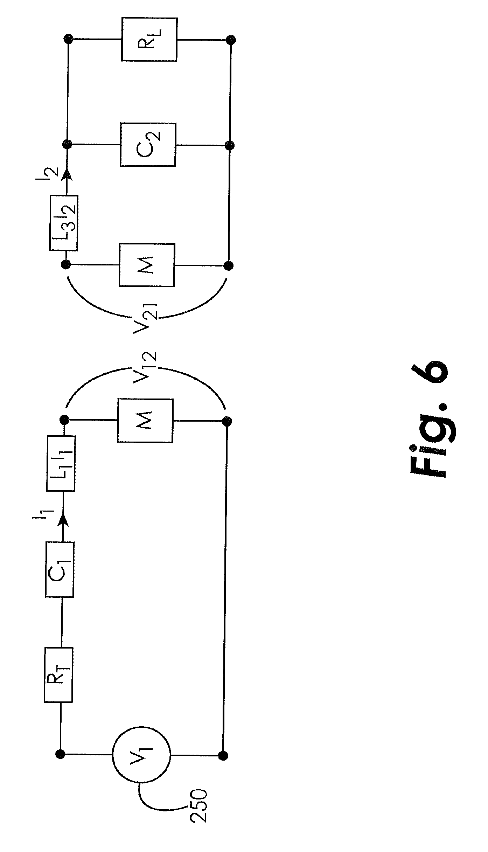

An equivalent circuit representing inductive coupling between a reader coil 100 powered by a voltage source 250 and a transponder coil 104 coupled to a load such as an RFID transponder is shown in FIG. 6. In the illustrated embodiment, the reader coil 100 is tuned using series resonance, while the transponder coil 104 is tuned using parallel resonance. Series resonance maximizes the current on the reader coil 100 and generates maximum magnetic field strength, whereas parallel resonance maximizes induced voltage on the transponder coil 104. Depending on the application, it may be preferred to have series resonance, parallel resonance or no resonance at all at the reader coil 100 and/or the transponder coil 104. It should be noted that $L_{11}$ and $L_{12}$ are the leakage inductances of $L_1$ and $L_2$, respectively, M is the mutual inductance, and $V_{12}$ and $V_{21}$ are the voltages across the mutual inductances such that

$$V_{12} = -jwMI_2$$

$$V_{21} = jwMI_1$$

where

$$M = k\sqrt{L_1 L_2}$$

$$L_1 = L_{11} + M$$

$$L_2 = L_{12} + M$$

and k is the coupling factor.

It is assumed for all circuits that the capacitors used have high quality factors so that their loading effect is negligible. The presence of the transponder coil 104 and structural components may introduce equivalent shunt resistance and shunt capacitance to the reader coil 100 due to an eddy effect and reduce its quality factor. In an embodiment, parallel-to-series conversion can be applied to convert these shunt elements to resistance and capacitance that are in series with the reader coil 100. Therefore, the total resistance, $R_T$, at the reader coil 100 will be a series combination of coil resistance, source resistance and the series resistance obtained due to the presence of transponder coil 104 and any structural components. Likewise, the tuning capacitor, $C_1$, includes the series capacitance obtained due to the presence of the transponder coil 104 and any structural components. Similarly, the total resistance, $R_L$, at the transponder coil 104 will be a parallel combination of coil resistance, load resistance and the parallel resistance obtained due to the presence of reader coil 100 and any structural components. Likewise, the tuning capacitor, $C_2$, includes the parallel capacitance obtained due to the presence of the reader coil 100 and any structural components. Power transfer efficiency, $\eta_p$, between the source 250 at the reader coil 100 and the load at the transponder coil 104 can be expressed as

$$\eta_P \approx \frac{k^2 Q_{1L} Q_{2L}^2}{(1 + k^2 Q_{1L} Q_{2L}) Q_C}$$

where

$$Q_{1L} = wL_1/R_T$$

$$Q_{2L} \approx \frac{wL_2}{R_2 + \dfrac{L_2}{C_2 R_C}}$$

$$Q_C = wC_2 R_C$$

where $R_C$ is the equivalent resistance of the load.

For a given coupling factor between coils, maximum power transfer occurs at a certain load level, or at a certain equivalent load resistance. With increasing coupling factor, however, maximum power transfer occurs at lower load value, or equivalent load resistance. This, in turn, results in decreased quality factor at the transponder coil 104. Alternatively, for a given load, the coupling factor may be adjusted by changing the distance between the coils to maximize power transfer. Hence, maximizing both the coupling factor and the quality factor may not be possible to maximize power transfer.

Environmental factors such as vibration and temperature variation will affect the tuning and the quality factors of the coils 100, 104. Therefore, the quality factors of the coils 100, 104 should be reasonably moderate so that the design will not be very sensitive to their variations, but the design should not rely on very high quality factors. Known changes in parameters with temperature can be used in combination with a temperature sensor to compensate for temperature effects at either the transponder coil 104 or the reader coil 100.

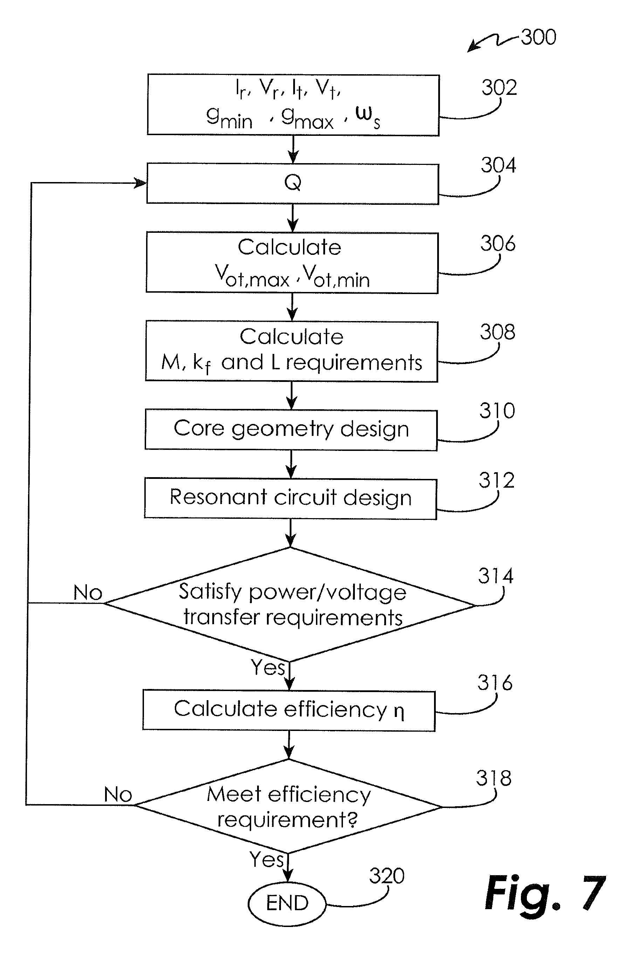

As a result, the design of coils, ferrite core geometry and resonant circuits need to take variations of the coupling factor and the quality factors into consideration. Ranges of variations in environmental factors and structural movements can typically be predicted by measurements or simulations, which can be used to find the expected variations in the coupling factor and the quality factors. FIG. 7 shows an iterative embedded sensing system design process, indicated generally at 300, that can accommodate a wide range of operating conditions.

At block 302, the required operating current $I_r$ and voltage $V_r$ of the reader coil 100, the required operating current $I_t$ and voltage $V_t$ of the transponder coil 104, the minimum air gap $g_{min}$ and maximum air gap $g_{max}$ between the coils 100, 104, and the resonant frequency $\omega_s$ are determined. At block 304, the desired loaded and unloaded quality factors of the coils 100, 104 are determined. The minimum output voltage $V_{ot,min}$ and maximum output voltage $V_{ot,max}$ of the transponder coil 104 required to power the device coupled to the transponder coil 104 is determined at block 306. At block 308, the mutual inductance M, coupling factor k and inductance L requirements for the reader and transponder coils are calculated. Based upon the factors determined above, an initial core geometry design, including number of coil winding turns, and winding properties (e.g., wire gauge and wire properties, such as conductivity, to name just two non-limiting examples) is determined at step 310, and an initial resonant circuit design is determined at block 312 based upon the core geometry design selected at block 310. At block 314, it is determined whether the designs selected at blocks 310 and 312 satisfy the voltage transfer requirements determined at block 306. This determination may be made by constructing the coils and resonant circuits and testing them, or by simulating their performance using electromagnetic simulation software modeling the coil design coupled with circuit simulation software modeling the resonant circuit design. If the designs selected at blocks 310 and 312 do not satisfy the voltage transfer requirements determined at block 306, the process 300 returns to block 304 where the quality factors of the coils 100, 104 may be adjusted to maximize the power transfer by modifying the ferrite core geometry, the number of turns in the coils, the properties of the windings, etc. The iterative design process of blocks 306-314 is then repeated. Alternatively, if the minimum air gap $g_{min}$ and maximum air gap $g_{max}$ between the coils 100, 104 may need to be changed, this will allow a different coupling factor k to be achieved and the quality factors of the coils 100, 104 will not need to be changed, but for most applications the minimum air gap $g_{min}$ and maximum air gap $g_{max}$ between the coils 100, 104 are design limitations that are imposed based upon the requirements of the system into which the reader coil 100 and the transponder coil 104 are to be integrated.

If the designs selected at blocks 310 and 312 are determined at block 314 to satisfy the voltage transfer requirements determined at block 306, the process 300 moves to block 316, where the power transfer efficiency $\eta_p$ is calculated. At block 318, it is determined whether the designs selected at blocks 310 and 312 meet the predetermined power transfer efficiency requirements. If so, the coil and resonant circuit design process is complete and the process 300 ends at block 320. If not, then the process 300 returns to block 304 where the quality factors of the coils 100, 104 may be adjusted to maximize the power transfer and the ferrite core geometry may be modified to improve the coupling factor. The iterative design process of blocks 306-314 is then repeated.

While the invention has been illustrated and described in detail in the drawings and foregoing description, the same is to be considered as illustrative and not restrictive in character, it being understood that only certain embodiments have been shown and described and that all changes and modifications that come within the scope of the claims are desired to be protected.

**Claims**

1. An inductively coupled sensor comprising:

    a first structure (102);

a reader coil (100) substantially disposed about an axis (110) and at least partially embedded in the first structure (102);

a second structure (106);

a transponder coil (104) substantially disposed about the axis (110) at least partially embedded in the second structure (106); and

a member (108) operatively coupled to the first structure (102) and to the second structure (106), the member (108) constructed and arranged to constrain movement of the first structure (102) with respect to the second structure (106).

2. The inductively coupled sensor of claim 1, wherein the member (108) comprises a rigid member.

3. The inductively coupled sensor of claim 1 or 2, wherein the member (108) allows rotational movement of the first structure (102) with respect to the second structure (106).

4. The inductively coupled sensor of claim 1, 2 or 3, wherein the member (108) allows movement along the axis (110) of the first structure (102) with respect to the second structure (106).

5. The inductively coupled sensor of any preceding claim, wherein the member (108) is operative to slide with respect to the first structure (102) in order to permit movement along the axis (110) of the first structure (102) with respect to the second structure (106).

6. The inductively coupled sensor of claim 5, further comprising a channel (114) disposed within the first structure (102), wherein a portion of the member (108) is disposed within the channel (114) and the member (108) is operative to slide within the channel (114) in order to permit movement along the axis (110) of the first structure (102) with respect to the second structure (106).

7. A method for aligning an inductively coupled sensor comprising a reader coil (100), a reader resonant circuit, a transponder coil (104), and a transponder resonant circuit, the method comprising:

a) maintaining one of the transponder coil (104) and the reader coil (100) stationary;
b) exciting the reader coil (100) at a frequency and a first voltage amplitude;
c) changing a position of an other of the transponder coil (104) and the reader coil (100) with respect to the coil (100, 104) maintained stationary in step (a);
d) measuring a current in the reader resonant circuit at a present position of the transponder coil (104) and the reader coil (100);
e) determining if the current in the reader resonant circuit is substantially at an extreme value;
f) if it is determined at step (e) that the current in the reader resonant circuit is substantially at the extreme value, determining that the present positions of the reader coil (100) and the transponder coil (104) are aligned; and
g) if it is determined at step (e) that the current in the reader resonant circuit is not substantially at the extreme value, repeating steps (c) - (g).

8. The method of claim 7, further comprising a method for tuning the inductively coupled sensor, the method for tuning comprising:

h) sweeping a frequency of a voltage source (250) of the reader coil (100) across a predetermined range of frequencies;
i) determining a reader resonant circuit resonant frequency within the predetermined range of frequencies at which a voltage induced across the transponder coil (104) is substantially maximized; and
j) adjusting a tuning of the transponder resonant circuit such that a transponder resonant circuit resonant frequency is substantially the same as the reader resonant circuit resonant frequency.

9. The method of claim 8, wherein step (j) comprises:

j.1) applying a first current to the transponder resonant circuit;
j.2) determining second current induced in the reader coil (100) by the first current;
j.3) adjusting a capacitance of the transponder resonant circuit;
j.4) determining a third current in the reader resonant circuit required to produce the first current in the transponder resonant circuit;
j.5) determining if the third current in the reader resonant circuit is substantially maximized;
j.6) determining that the reader resonant circuit resonant frequency is substantially the same as the transponder resonant circuit resonant frequency, based on determining at step (j.5) that the third current in the reader resonant circuit is substantially maximized; and
j.7) repeating steps (j.3) - (j.6) based on determining at step (j.5) that the third current in the reader resonant circuit is not substantially maximized.

10. The method of claim 8, wherein the reader resonant circuit comprises series resonance and the transponder resonant circuit comprises parallel resonance.

**11.** The method of claim 9 or 10, wherein step (j.3) comprises adjusting a voltage applied to a voltage controlled variable capacitance within the transponder resonant circuit.

**12.** The method of claim 11, wherein the voltage controlled variable capacitance comprises a varactor diode.

**13.** A method for designing an inductively coupled sensor comprising a reader coil (100), a reader resonant circuit, a transponder coil (104), and a transponder resonant circuit that satisfy a predetermined power transfer requirement and a predetermined power transfer efficiency requirement, the method comprising:

a) determining a minimum output voltage and a maximum output voltage for powering a device coupled to the transponder coil (104);
b) determining a mutual inductance, a coupling factor, a reader coil inductance and a transponder coil inductance;
c) determining a reader coil design and a transponder coil design;
d) determining whether the reader coil design and the transponder coil (104) design satisfies the predetermined power transfer requirement;
e) selecting a different value for at least one of an unloaded reader coil quality factor, a loaded reader coil quality factor, an unloaded transponder coil quality factor, and a loaded transponder coil quality factor and repeating steps (a) - (g), based on determining at step (d) that the reader coil design and the transponder coil design do not satisfy the predetermined power transfer requirement;
f) determining whether the reader coil design and the transponder coil designs satisfy the predetermined power transfer efficiency requirement, based on determining at step (d) that the reader coil design and the transponder coil design do satisfy the predetermined power transfer requirement; and
g) selecting a different value for at least one of the unloaded reader coil quality factor, the loaded reader coil quality factor, the unloaded transponder coil quality factor, and the loaded transponder coil quality factor and repeating steps (a) - (g), based on determining at step (f) that the reader coil design and the transponder coil design satisfy the predetermined power transfer efficiency requirement.

**14.** The method of claim 13, wherein step (c) comprises determining a reader coil core geometry design, a number of reader coil winding turns, the reader coil winding properties, a reader resonant circuit design, a transponder coil core geometry design, a number of transponder coil winding turns, the transponder coil winding properties, and a transponder resonant circuit design.

**Fig. 1**

EP 3 032 757 A2

**Fig. 2**

**Fig. 3**

**Fig. 4**

```
                                                         200
    ┌─────────────────────────────┐          ⌐
    │   Maintain the transponder coil │       )
    │          stationary            │
    └─────────────────────────────┘
                    │
                    ▼
                                                         202
    ┌─────────────────────────────┐          ⌐
    │    Excite the reader coil at a │       )
    │  fixed frequency and voltage  │
    │           amplitude           │
    └─────────────────────────────┘
                    │
                    ▼
                                                         204
    ┌─────────────────────────────┐          ⌐
    │    Move the reader coil and   │       )
    │    monitor the current at the │
    │            source             │
    └─────────────────────────────┘
                    │
                    ▼
                    ◇
              ╱           ╲                              206
            ╱               ╲       ⌐
          ╱     Current       ╲    )
    No  ◇   in reader coil at an  ◇
          ╲   extreme value?    ╱
            ╲               ╱
              ╲           ╱
                    │
                   Yes
                    │
                    ▼
                                                         208
    ┌─────────────────────────────┐          ⌐
    │      Coils are aligned        │       )
    └─────────────────────────────┘
```

# Fig. 5

**Fig. 6**

~300

$I_r, V_r, I_t, V_t,$
$g_{min}, g_{max}, \omega_s$ — 302

Q — 304

Calculate
$V_{ot,max}, V_{ot,min}$ — 306

Calculate
$M, k_f$ and L requirements — 308

Core geometry design — 310

Resonant circuit design — 312

No ← Satisfy power/voltage
transfer requirements — 314

Yes

Calculate efficiency η — 316

No ← Meet efficiency
requirement? — 318

Yes

END — 320

*Fig. 7*